# EUROPEAN PATENT APPLICATION

(11) **EP 4 016 638 A1**
(43) Date of publication of application: **22.06.2022**
(21) Application number: 20216115.4
(22) Date of filing: 21.12.2020
(51) Int. Cl.: H01L 29/06, H01L 29/10, H01L 29/40, H01L 29/423, H01L 29/739, H01L 29/417

(54) **POWER SEMICONDUCTOR DEVICE WITH AN INSULATED TRENCH GATE ELECTRODE**

(71) Applicant: Hitachi Energy Switzerland AG, 5400 Baden (CH)
(72) Inventor: DE MICHIELIS, Luca, 5000 Aarau (CH); GUPTA, Gaurav, 5600 Lenzburg (CH); VITALE, Wolfgang Amadeus, 5000 Aarau (CH); BUITRAGO, Elizabeth, 5210 Windisch (CH); CORVASCE, Chiara, 8962 Bergdietikon (CH)
(74) Representative: Epping - Hermann - Fischer

(57) **Abstract**

A power semiconductor device (1) with a semiconductor body (2) extending in a vertical direction between an emitter side (21) with an emitter electrode (51) and a collector side (22) opposite the emitter side (21) is specified, the power semiconductor device (1) comprising:
- a drift layer (26) of a first conductivity type;
- a base layer (28) of a second conductivity type different than the first conductivity type extending between the drift layer (26) and the emitter side (21);
- a source region (29) of the first conductivity type arranged on a side of the base layer (28) facing away from the drift layer (26);
- at least one first trench (3) extending from the emitter side (21) into the drift layer (26);
- an insulated trench gate electrode (30) extending into the first trench (3);
- at least one second trench (4) extending from the emitter side (21) into the drift layer (26), the at least one second trench (4) being arranged on a side of the at least one first trench (3) facing away from the source region (29);
- an electrically conductive layer (41) extending into the second trench (4), the electrically conductive layer (41) being electrically insulated from the base layer (28) and the drift layer (26);
wherein
- a portion (281) of the base layer (28) arranged on a side of the at least one second trench (4) facing away from the at least one first trench (3) extends from the emitter side (21) at least as deep in the vertical direction towards the collector side (22) as the at least one second trench (4); and
- a sub-region (6) of the power semiconductor device (1) extending between the at least one first trench (3) and the at least one second trench (4) comprises a charge carrier extraction contact (61) electrically connected to the base layer (28).

## Description

The present disclosure relates to a power semiconductor device with an insulated trench gate electrode, for instance to an insulated gate bipolar transistor (IGBT).

Documents US 9,825,158 B2 and US 2020/0006539 A1 relate to an insulated gate bipolar transistor with an insulated trench gate electrode.

It has been found that hot carrier injection into the gate oxide is a typical trench degradation mechanism associated with the loss of long-term stability in trench IGBTs. Injected charge carriers can become trapped at the interface between the silicon semiconductor material and the trench oxide, especially at the trench bottom. During turn-off the current consists mostly of holes being displaced during the expansion of the depletion layer. Holes are accelerated towards the trench bottom by the high electric field in the depletion layer, especially during the overvoltage phase of hard turn-off switching events.

An object to be solved is to provide a power semiconductor device with improved long-term stability.

Exemplary embodiments of the disclosure address the above shortcomings, inter alia, for example a power semiconductor device according to claim 1. Further configurations and developments are the subject-matter of the dependent claims.

According to at least one embodiment of the power semiconductor device, the power semiconductor device comprises a semiconductor body extending in a vertical direction between an emitter side with an emitter electrode and a collector side opposite the emitter side. The power semiconductor device comprises a drift layer of a first conductivity type, a base layer of a second conductivity type different than the first conductivity type extending between the drift layer and the emitter side. The power semiconductor device further comprises a source region of the first conductivity type arranged on a side of the base layer facing away from the drift layer and at least one first trench extending from the emitter side into the drift layer wherein an insulated trench gate electrode extends into the first trench. The power semiconductor device further comprises at least one second trench extending from the emitter side into the drift layer wherein an electrically conductive layer extends into the second trench, the electrically conductive layer being electrically insulated from the base layer and the drift layer. The at least one second trench is arranged on a side of the at least one first trench facing away from the source region. A portion of the base layer arranged on a side of the at least one second trench facing away from the at least one first trench extends from the emitter side at least as deep in the vertical direction towards the collector side as the at least one second trench.

Contrary to the first trench, the second trench is electrically inactive and may also be referred to as a dummy trench. For example, electrically inactive means that there is no electrically conductive channel formed along the at least one second trench in an on-state of the power semiconductor device. For example, the at least one first trench is arranged between the source region and the at least one second trench, so that the second trench is separated from the source region via the first trench. It has been found that the portion of the base layer that extends comparably deep towards the collector side helps to significantly reduce the avalanche intensity near the first trench acting as active trench, for example compared to a design where the depth of the base layer is the same on both sides of the second trench.

If the doping concentration of the portion of the base layer does not abruptly decrease in vertical direction, for instance due to an implant tail of the dopants, the depth of the portion may be determined using that vertical position, where the doping concentration of the portion of the second conductivity type has decreased to the doping concentration of the dopants of the first conductivity type in the drift layer.

The first conductivity type may be n-type and the second conductivity type may be p-type or vice versa.

For example, a bottom of the trench directly adjoins the portion of the base layer in regions.

For example, the insulated trench gate electrode is electrically insulated from at least one of the semiconductor body and the electrically conductive layer. The electrically conductive layer is not in direct electrical contact with the at least one second trench, for instance.

During turn-off of the power semiconductor device, charge carriers, for instance holes in the case of a p-type base layer, may be extracted via the charge carrier extraction contact. In other words, the charge carrier extraction contact represents a plasma control feature that helps to further reduce the avalanche generation near the first trench.

It has been found that in the presence of the charge carrier extraction contact, a significant amount of injected holes may get diverted away from the first trench acting as active trench. Moreover, the second trench may electrostatically shield the active trench thereby protecting the first trench with the insulated trench gate electrode. The sub-region may be electrostatically screened by the first trench and the second trench which facilitates a controlled plasma extraction during a turn-off switching event without compromising the static losses too much. Consequently, a robust power semiconductor device with decreased degradation may be obtained without significant impact on the device performance.

The charge carrier extraction may be controlled via the electrical voltage applied to the charge carrier extraction contact. The applied voltage may correspond to the voltage at the emitter electrode or be different therefrom.

According to at least one embodiment of the power semiconductor device, during operation of the power semiconductor device, the charge carrier extraction contact is electrically addressable separately from the emitter electrode. Thus, the applied voltage may be independent from the voltage at the emitter electrode. For example, the voltage applied to the charge carrier extraction contact is positive with respect to the emitter electrode or the same as the voltage at the emitter electrode. For example, the voltage at the charge carrier extraction contact differs for different states during operation. For example, a positive voltage during an on-state may prevent excessive charge charrier extraction. During an off-state or a switching into the off-state, the voltage at the charge carrier extraction contact may be negative with respect to emitter electrode in order to enhance the charge carrier extraction.

According to at least one embodiment of the power semiconductor device, the charge carrier extraction contact is electrically connected to the emitter electrode. Thus, the voltage at the charge carrier extraction contact corresponds to that of the voltage at the emitter electrode.

The impact of the second trench on the power semiconductor device may further be controlled via a voltage applied to the electrically conductive layer in the second trench.

According to at least one embodiment of the power semiconductor device, the electrically conductive layer is at the same voltage as the emitter electrode or at a positive voltage with respect to the emitter electrode during operation of the power semiconductor device. For example, the electrically conductive layer is at a voltage applied to the emitter electrode or at a voltage applied to the insulated trench gate electrode. However, the applied voltage may also differ from both the voltage at the insulated trench gate electrode and the voltage at the emitter electrode.

According to at least one embodiment of the power semiconductor device, the charge carrier extraction contact is subdivided into a plurality of segments. For example, the segments are arranged beside one another in a direction extending in parallel to a main extension direction of the at least one first trench. However, a single charge carrier contact without any segments may also be used.

For example, a proportion of the emitter side covered by the segments of the charge carrier extraction contact along a straight line extending in parallel to the main extension direction of the at least one first trench amounts to at least 0.1 % or at least 10 % or at least 30 % and/or at most 90 % or at most 80 %.

According to at least one embodiment of the power semiconductor device, the sub-region and the source region are arranged laterally beside one another when seen onto the emitter side. In other words, there is no source region between the first trench and the second trench.

According to at least one embodiment of the power semiconductor device, an edge-to-edge distance between the at least one first trench and the at least one second trench is between 0.5 µm and 5 µm inclusive. It has been found that the percentage of the avalanche generation shared by the second trench reduces as the spacing between the first trench and the second trench increases. Thus, placing the second trench as close as possible to the first trench would be of advantage in terms of the protection of the first trench. However, a spacing which is too small may result in higher turn-off losses.

According to at least one embodiment of the power semiconductor device, the at least one first trench and the at least one second trench have the same depth in the vertical direction. Consequently, the at least one first trench and the at least one second trench may be produced in a common process step.

The term "same depth" also includes minor differences of the depth within fabrication tolerances. However, the depth of the first trench and the second trench may also differ from one another if appropriate.

According to at least one embodiment of the power semiconductor device, an enhancement layer of the first conductivity type is arranged in regions between the drift layer and the base layer, wherein the enhancement layer is more heavily doped than the drift layer.

For example, a maximum doping concentration of the enhancement layer is larger than a maximum doping concentration of the drift layer at least by a factor of 50 or a factor of 100.

The enhancement layer may act as a charge carrier barrier, thereby reducing the on-state losses.

According to at least one embodiment of the power semiconductor device, the enhancement layer is arranged between the at least one first trench and the at least one second trench. Thus, a part of the enhancement layer may also be present in the sub-region. By means of the enhancement layer placed in the sub-region between the first trench and the second trench, on-state losses via the charge carrier extraction contact may further be reduced. However, the sub-region between the first trench and the second trench may also be free of the enhancement layer.

According to at least one embodiment of the power semiconductor device, the portion extends below the at least one second trench towards the at least one first trench. For example, the second trench completely overlaps with the portion when seen in vertical direction. For example, the portion extends beyond the second trench when seen towards the first trench, but does not overlap with the charge carrier extraction contact when seen in vertical direction. The portion may extend even further towards the first trench. For example, the sub-region completely overlaps with the portion when seen in vertical direction. For example, the first trench overlaps with the portion when seen in vertical direction completely or at least in regions.

According to at least one embodiment of the power semiconductor device, the portion of the base layer extends in a cross-sectional view of the power semiconductor device in a lateral direction between two partial regions of the at least one second trench. The two partial regions may be formed by one contiguous second trench or by two separate second trenches. For example, the portions of the at least one second trench extend in parallel to one another, for instance spaced apart from one another in a direction running perpendicular to the main extension direction of the at least one first trench.

According to at least one embodiment of the power semiconductor device, the at least one second trench contiguously forms the two partial regions of the second trench. However, the two partial regions of the second trench may also be formed by two separate second trenches.

According to at least one embodiment of the power semiconductor device, the at least one second trench forms a closed loop enclosing the portion of the base layer when seen in the vertical direction. The portion of the base layer may be spaced apart from the closed loop in regions. For example, outside of the closed loop the base layer does not extend at least as deep in the vertical direction as the at least one second trench at any position.

According to at least one embodiment of the power semiconductor device, the two partial regions of the at least one second trench are arranged between two partial regions of the at least one first trench in a cross-sectional view of the power semiconductor device. For example, the portions of the at least one first trench extend in parallel to one another, for instance spaced apart from one another in a direction running perpendicular to the main extension direction of the at least one first trench. For example, the at least one first trench contiguously forms the two partial regions of the first trench. However, the two partial regions of the second trench may also be formed by two separate first trenches. For example, the at least one first trench forms a closed loop enclosing the at least one second trench, which may be formed as a closed loop, for instance.

According to at least one embodiment of the power semiconductor device, the power semiconductor device is a trench IGBT.

A trench IGBT (insulated gate bipolar transistor) comprises on an emitter side (also called source side) a source region (also called emitter layer) of a first conductivity type and a base layer (also called well layer) of a second conductivity type different than the first conductivity type. A contact in form of an emitter electrode (also called source electrode) contacts the source region and the base layer. An insulated trench gate electrode is arranged on the emitter side lateral to the source region and the base layer.

The inventive concept may be applied to different types of IGBTs such as conventional punch-through IGBTs, non-punch-through IGBTs (NPT-IGBTs), reverse-blocking IGBTs or reverse-conducting IGBTs. Furthermore, it may be applied to other power semiconductor devices with an insulated trench gate electrode.

The semiconductor body of the power semiconductor device may be based on silicon. However, other semiconductor materials may also be used, for example wide bandgap materials such as silicon carbide (SiC) or gallium nitride (GaN).

For example, the power semiconductor device is configured for operating at large electrical currents, for instance of at least hundred amperes and/or at large electrical voltages of at least 500 V.

Further aspects of the disclosure will become apparent from the following description of the exemplary embodiments and figures. In the exemplary embodiments and figures similar or similarly acting constituent parts are provided with the same reference signs. Generally, only the differences with respect to the individual embodiments are described. Unless specified otherwise, the description of a part or aspect in one embodiment applies to a corresponding part or aspect in another embodiment as well.

In the Figures:
- Figures 1A to 1F: show an exemplary embodiment of a power semiconductor device, wherein Figure 1A represents a sectional view, Figure 1B illustrates a sectional view together with a portion of an associated schematic top view, Figure 1C illustrates a portion of a schematic top view, Figures 1D and 1E illustrate sectional views along the lines DD' and EE' of Figure 1C, respectively, and Figure 1F illustrates a sectional view together with a further portion of an associated schematic top view;
- Figure 2A: shows simulation results of a time integrated avalanche generation A for the described power semiconductor device and for two reference designs R1 and R2 shown in Figures 2B and 2C, respectively;
- Figure 3A: shows simulation results for the time integrated avalanche generation A near the first trench and the second trench for designs with and without a charge carrier extraction contact;
- Figure 3B: shows simulation results for the time integrated avalanche generation A for designs with and without a charge carrier extraction contact and an associated ratio between the avalanche generation near the second trench and near the first trench as a function of an edge-to-edge distance s1 between the first trench and the second trench;
- Figure 4: shows a further exemplary embodiment of a power semiconductor device.

The elements illustrated in the figures and their size relationships among one another are not necessarily true to scale. Rather, individual elements or layer thicknesses may be represented with an exaggerated size for the sake of better representability and/or for the sake of better understanding.

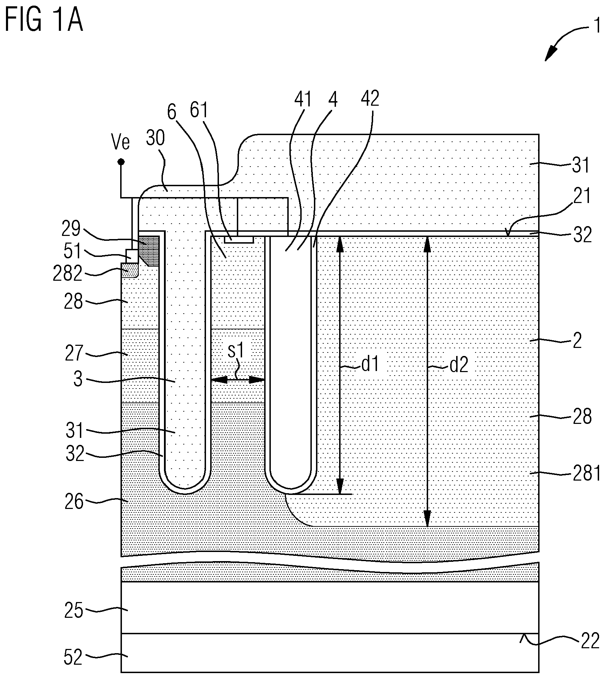

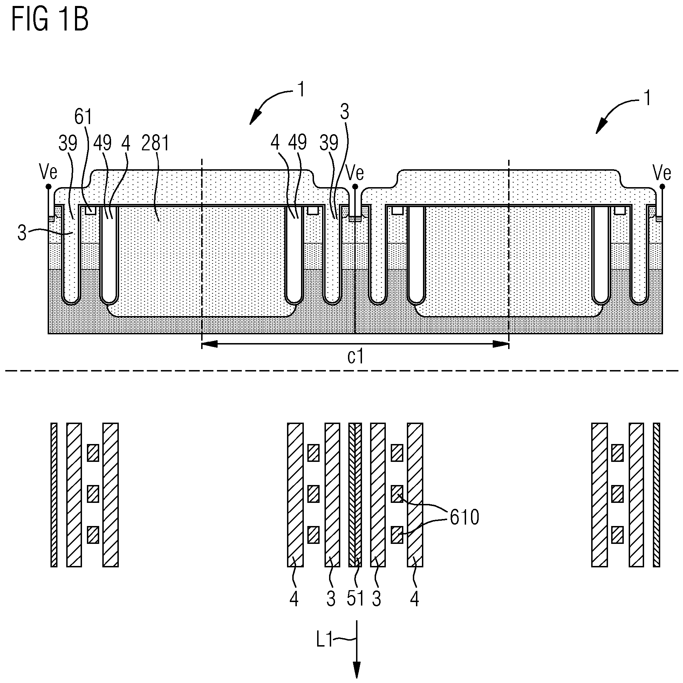

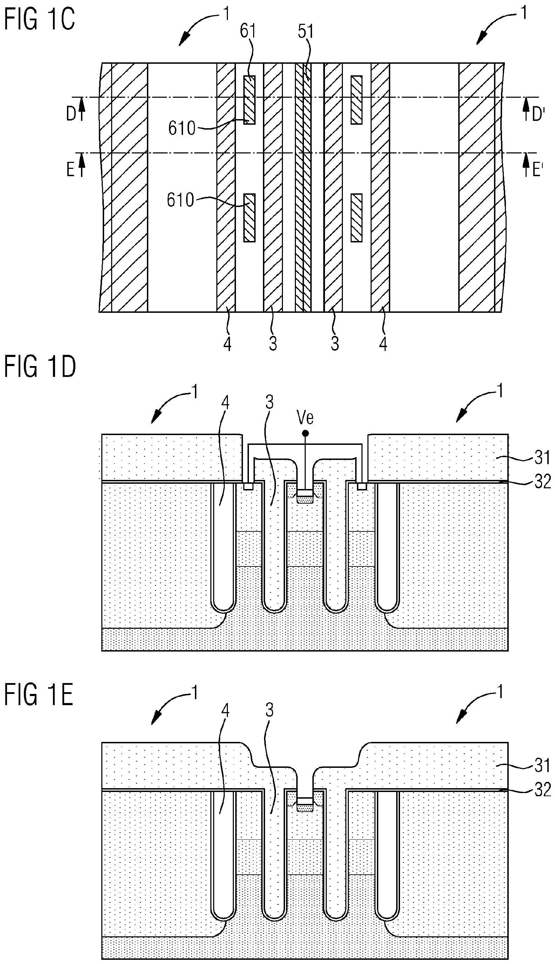

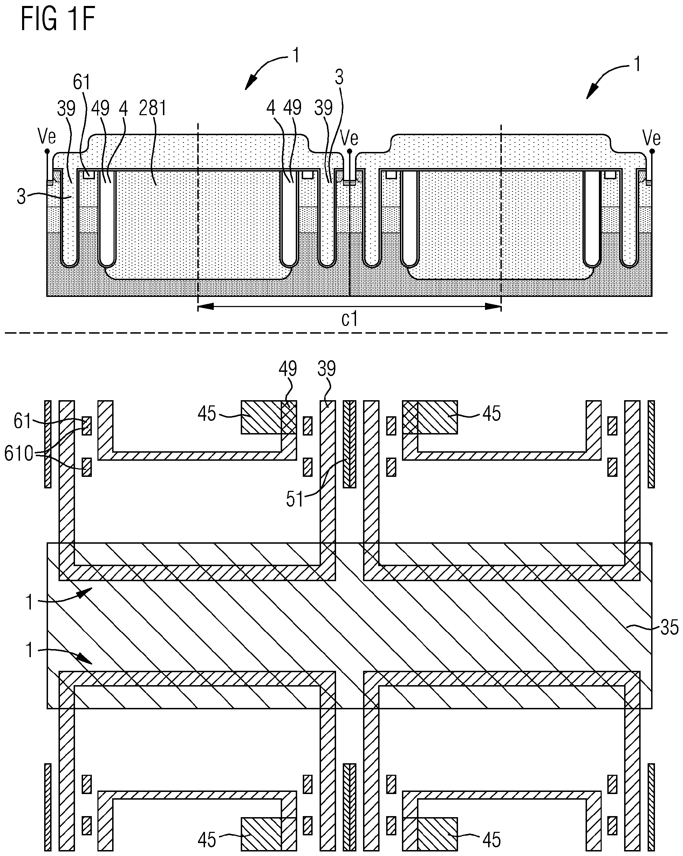

A detail of a power semiconductor device 1 is illustrated in Figure 1A in a schematic sectional view. The views of Figures 1B and 1F illustrate power semiconductor devices 1 embodied as cells being arranged laterally beside one another.

The power semiconductor device 1 comprises a semiconductor body 2 extending in a vertical direction between an emitter side 21 with an emitter electrode 51 and a collector side 22 opposite the emitter side 21.

The power semiconductor device 1 comprises a drift layer 26 of a first conductivity type, a base layer 28 of a second conductivity type different than the first conductivity type extending between the drift layer 26 and the emitter side 21. A source region 29 of the first conductivity type is arranged on a side of the base layer 28 that faces away from the drift layer 26.

In the subsequent description of the exemplary embodiments the first conductivity type is n-type and the second conductivity type is p-type so that the base layer 28 is a p-type layer. However, the layers may also be inverted with respect to their conductivity type.

The power semiconductor device 1 comprises a first trench 3 and a second trench 4. The first trench 3 and the second trench 4 extend from the emitter side 21 into the drift layer 26. An insulated trench gate electrode 30 comprising a gate electrode layer 31 which is electrically conductive and a gate insulation layer 32 extends into the first trench 3. The gate electrode layer 31 is electrically insulated from the semiconductor body 2. During operation of the power semiconductor device 1 the first trench 3 represents an active trench at the potential level of the gate voltage.

The second trench 4 is arranged on a side of the first trench 3 facing away from the source region 29 and does not represent an active trench. An electrically conductive layer 41 extends into the second trench 4. The electrically conductive layer 41 is electrically insulated from the drift layer 26 and the base layer 28. The emitter electrode 51 is arranged at the emitter side 21. The first trench 3 and the second trench 4 may have the same depth, so that they can be formed in a common process step.

In the exemplary embodiment shown, the second trench 4 is electrically insulated from the insulated trench gate electrode 30 and is electrically connected to the emitter electrode 51.

However, the electrically conductive layer 41 may also be electrically separated from the emitter electrode 51. For example, the electrically conductive layer 41 is at the same voltage as the emitter electrode 51 or at a positive voltage with respect to the emitter electrode 51 during operation of the power semiconductor device 1. For example, the electrically conductive layer 41 is at the voltage applied to the emitter electrode or at the voltage applied to the insulated trench gate electrode 3. However, the applied voltage may also differ from both the voltage at the insulated trench gate electrode 3 and the voltage at the emitter electrode. A positive voltage applied to the electrically conductive layer 41 may provide an improved electrostatic shielding of the sub-region 6.

In the exemplary embodiment of Figure 1A the emitter electrode 51 electrically contacts the base layer 28 laterally beside the source region 29 in a recess of the semiconductor body 2 formed in the emitter side 21. The emitter electrode 51 directly adjoins the source region 29 and a contact portion 282 of the base layer 28 which is more heavily doped than the rest of the base layer 28. However, the emitter electrode 51 may also be provided on the emitter side 21.

On a side of the second trench 4 that faces away from the first trench 3 the base layer 28 comprises a portion 281 having a depth d2 which is larger than or at least as large as a depth d1 of the second trench 4. For example, the portion 281 of the base layer 28 extends from the emitter side 21 deeper in the vertical direction towards the collector side 22 than the second trench 4. For example, the difference d2 - d1 is between 0 µm and 5 µm inclusive. The portion 281 directly adjoins a bottom of the second trench 4 in regions.

A sub-region 6 of the power semiconductor device 1 extending between the first trench 3 and the second trench 4 comprises a charge carrier extraction contact 61 via which the base layer 28 is electrically connected.

The sub-region 6 and the source region 29 are arranged on opposite sides of the first trench 3, so that the sub-region 6 is free of a source region. In the exemplary embodiment shown, the charge carrier extraction contact 61 is electrically connected to the emitter electrode 51. Thus, during operation of the power semiconductor device 1 the charge carrier extraction contact 61 may be at the emitter voltage Ve.

However, during operation of the power semiconductor device 1, the charge carrier extraction contact 61 may also be electrically addressable separately from the emitter electrode 51. Thus, the applied voltage may be independent from the voltage at the emitter electrode 51. For example, the voltage applied to the charge carrier extraction contact 61 is positive with respect to the emitter electrode 51 or the same as the voltage at the emitter electrode 51. For example, the voltage at the charge carrier extraction contact 61 differs for different states during operation.

It has been found that the second trench 4 acting as a dummy trench together with the portion 281 of the base layer 28 that extends deeper towards the collector side 22 than the second trench 4 results in a significant reduction of the avalanche generation during the turn-off switching of the power semiconductor device 1. Degradation of the gate insulation layer 32 caused by hot carriers may be eliminated or at least reduced in this manner.

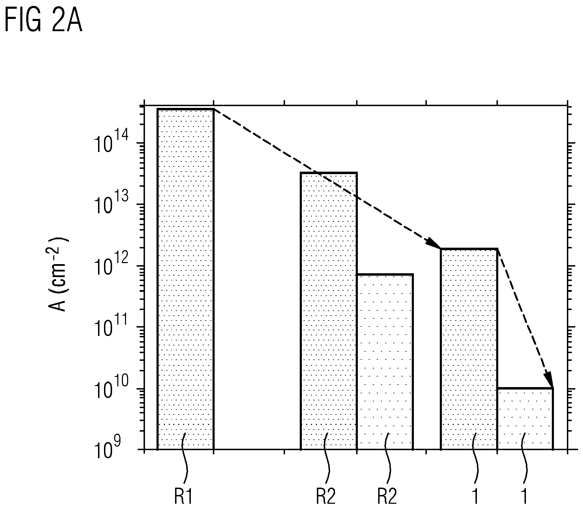

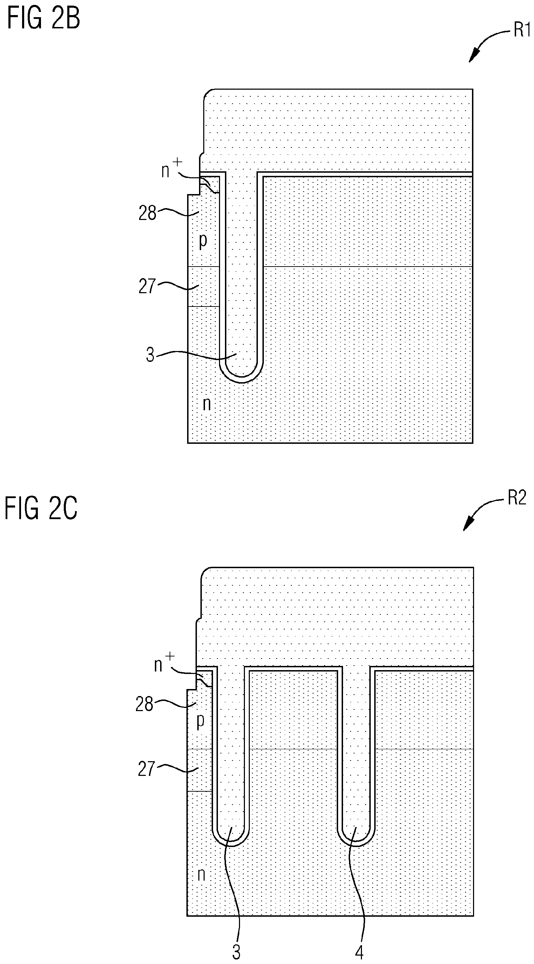

The reduced avalanche generation near the first trench 3 has been confirmed by simulations as illustrated in Figure 2A, comparing the time integrated avalanche generation per square centimetre during a turn-off switching near the first trench 3 for the power semiconductor device 1 with a first reference design R1 illustrated in Figure 2B and a second reference design R2 illustrated in Figure 2C. The reference design R1 only includes an active trench corresponding to the first trench 3 but no inactive trench. The reference design R2 includes an additional electrically inactive second trench 4. However, in both reference designs the base layer 28 has a continuous depth so that the depth of the base layer 28 is the same on both sides of the second trench 4.

Figure 2A illustrates simulation results for two options for the second reference design R2 and the power semiconductor device 1 wherein in each case the bar on the left-hand side shows the time integrated avalanche generation A during a turn-off switching near the first trench 3 for a design without a charge carrier extraction contact whereas the bar on the right-hand side shows the results for a design with a charge carrier extraction contact 61.

As Figure 2A illustrates, the time integrated avalanche generation A may be reduced by more than one order of magnitude compared to the reference design R2 and by two orders of magnitude with respect to the reference design R1 for the designs without a charge carrier extraction contact. The addition of the charge carrier extraction contact 61 results in a further reduction by two orders of magnitude.

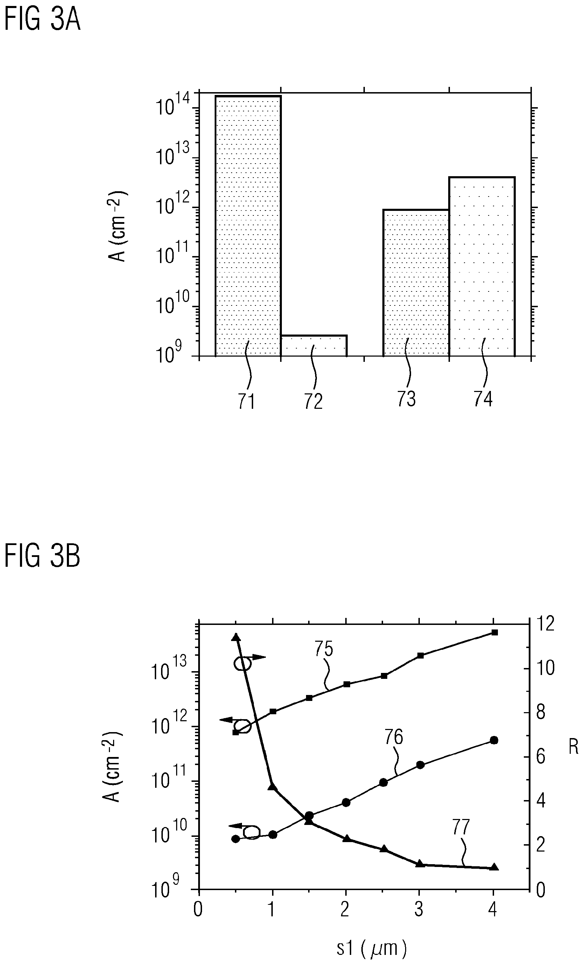

Figure 3A shows simulation results for a power semiconductor device 1 as described in Figure 1A in a bar diagram wherein bars 71 and 72 show the time integrated avalanche generation A near the first trench 3 (bar 71) and near the second trench 4 (bar 72) for a design without a charge carrier extraction contact 61. The bars 73 and 74 show corresponding simulation results with a charge carrier extraction contact 61. These simulations clearly show that the charge carrier extraction contact 61 allows the plasma distribution to be controlled such that most of the avalanche generation takes place near the second trench 4, thereby reducing the avalanche generation near the first trench 3.

Figure 3B further shows simulation results for the time integrated avalanche generation A for a power semiconductor device as described in connection with Figure 1A as a function of an edge-to-edge distance s1 between the first trench 3 and the second trench 4 wherein curve 75 refers to a design without a charge carrier extraction contact and curve 76 refers to a design with a charge carrier extraction contact 61. Curves 75 and 76 each refer to the avalanche generation near the first trench 3. Curve 77 shows the ratio R of the avalanche generation A between a region near the second trench 4 and near the first trench 3. For both curves 75 and 76 the avalanche generation A decreases with decreasing edge-to-edge distance s1. Furthermore, the ratio R increases with decreasing edge-to-edge distance s1. Consequently in terms of the protection of the first trench 3 acting as an active trench, it would be desirable to place the second trench 4 as close as possible to the first trench 3. However, a lower edge-to-edge distance s1 between the first trench 3 and the second trench 4 may not be favourable for minimizing the turn-off losses. Therefore there is a trade-off between the protection of the first trenches and the turn-off losses of the power semiconductor device cell which needs to be engineered as per the application requirements of the power semiconductor device 1.

The power semiconductor device 1 further comprises a collector layer 25. In an IGBT the collector layer 25 is of the second conductivity type. A collector electrode 52 is arranged on the collector side 22 of the power semiconductor device 1. The collector electrode 52 directly adjoins the collector layer 25. In the following figures only the upper part of the power semiconductor device 1 is shown in the cross-sectional views for the sake of easier representation.

The power semiconductor device 1 further comprises an optional enhancement layer 27 arranged between the drift layer 26 and the base layer 28 in regions. The enhancement layer 27 is a layer with a maximum doping concentration which is higher than the doping concentration of the drift layer 26 by at least a factor of 50. The enhancement layer 27 may act as a charge carrier barrier, for instance as a hole barrier for an n-type enhancement layer 27.

The enhancement layer 27 is also present in the sub-region 6 so that the enhancement layer 27 reduces the charge carrier extraction at the charge carrier extraction contact 61, thereby reducing the on-state losses.

The charge carrier extraction contact 61 still provides an additional escape path to the plasma during turn-off switching but at the same time limits the on-state losses due to the electrostatic screening of the sub-region 6 provided by the first trench 3 and the second trench 4.

For example, typical maximum doping concentrations may be between 1*10¹² cm⁻³ and 1*10¹⁴ cm⁻³ for an n⁻ drift layer 26, 3*10¹⁶ cm⁻³ for an n enhancement layer 27, 1.5*10¹⁷ cm⁻³ for a p base layer 28, 5*10¹⁷ cm-3 for the portion 281 of the base layer 28 and 1*10¹⁹ cm⁻³ for a p⁺ contact portion 282 of the base layer 28.

As shown in Figure 1B, the power semiconductor device 1 comprises two partial regions 39 of the first trench 3 and two partial regions 49 of the second trench 4 wherein the two partial regions 49 of the second trench 4 are arranged between the two partial regions 39 of the first trench 3 in a cross-sectional view perpendicular to a main extension direction L1 of the first trench 3. The portion 281 of the base layer 28 having the depth d2 larger than the depth d1 of the second trenches 4 is formed between the two partial regions 49 of the second trench 4.

As Figure 1F illustrates, the partial regions 49 of the second trench 4 may be formed by one contiguous second trench 4. Exemplarily the second trench 4 is formed as a closed loop when seen onto the emitter side 21. Likewise, the partial regions 39 of the first trench 3 may be formed by one contiguous first trench 3. Exemplarily the second trench 4 is formed as a closed loop when seen onto the emitter side 21.

The portion 281 of the base layer 28 is located completely within the closed loop formed by the second trench 4 when seen in vertical direction.

However, the partial regions 39 of the first trench 3 and/or the partial regions 49 of the second trenches 4 may also be formed by separate trenches in other designs.

Figure 1F further shows a gate connector 35 electrically connecting the gate electrode layer 31 in the first trenches 3 of the cells to a gate potential and a connector 45 electrically connecting the electrically conductive layer 41 in the second trenches 4 of the cells to an emitter potential Ve. However, the connector 45 may also be used to connect the electrically conductive layer 41 to another potential.

As shown in Figure 1C, the charge carrier extraction contact 61 may be divided into a plurality of segments 610. Depending upon the application needs the average center-to-center spacing between the segments 610 and their extension in a direction running in parallel to the main extension direction L1 may be varied within wide limits. For example the extension in the direction running in parallel to the main extension direction L1 is at least 0.1 % or at least 10 % or at least 20 % and/or at most 95 % or at most 80 %, for instance between 30 % and 50 % inclusive.

For example, the number of segments 610 amounts to between 20 and 200 per millimeter in a direction parallel to the main extension direction L1. However, a single segment may also be used instead.

For example, the power semiconductor device 1 has a cell design providing a stripe trench IGBT with a length of between 0.5 and 3 mm along the main extension direction L1. A cell pitch c1, i.e. a center-to-center distance between adjacent power semiconductor devices 1 in a direction perpendicular to the main extension direction L1 as illustrated in Figure 1B is between 10 µm and 500 µm inclusive, for example.

However, the proposed design may also apply for other power semiconductor devices and other design geometries.

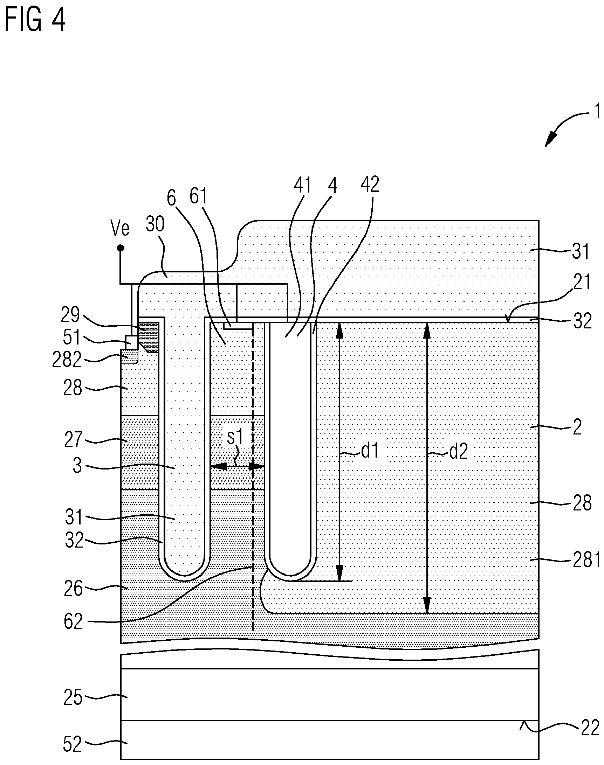

The exemplary embodiment shown in Figure 4 essentially corresponds to that described in connection with Figures 1A through 1F.

In departure therefrom, the power semiconductor device 1 the portion 281 extends below the second trench 4 in a direction towards the first trench 3. The second trench 4 completely overlaps with the portion when seen in vertical direction. For example, the portion 281 extends beyond the second trench 4 when seen towards the first trench 3, but does not overlap with the charge carrier extraction contact 61 when seen in vertical direction. This is illustrated using line 62 referring to the edge of the charge carrier extraction contact 61 at the side facing the second trench 4.

Unlike in the embodiment shown, the portion 281 may extend even further towards the first trench 3. For example, the sub-region 6 completely overlaps with the portion 281 when seen in vertical direction. In this case, the sub-region 281 may be completely of the second conductivity type. Alternatively, a part of the drift layer 26 and/or a part of the enhancement layer 27 may be located on a side of the portion 281 that faces the emitter side 21.

Furthermore, even the first trench 3 may overlap in regions or completely with the portion 281 when seen in vertical direction.

The disclosure described herein is not restricted by the description given with reference to the exemplary embodiments. Rather, the disclosure encompasses any novel feature and any combination of features, including in particular any combination of features in the claims, even if this feature or this combination is not itself explicitly indicated in the claims or exemplary embodiments.

### List of Reference Signs

- 1: power semiconductor device
- 2: semiconductor body
- 21: emitter side
- 22: collector side
- 25: collector layer
- 26: drift layer
- 27: enhancement layer
- 28: base layer
- 281: portion of the base layer
- 282: contact portion of the base layer
- 29: source region
- 3: first trench
- 30: insulated trench gate electrode
- 31: gate electrode layer
- 32: gate insulation layer
- 35: gate connector
- 39: partial region of first trench
- 4: second trench
- 41: electrically conductive layer
- 42: electrically insulating layer
- 45: connector
- 49: partial region of second trench
- 51: emitter electrode
- 52: collector electrode
- 6: sub-region
- 61: charge carrier extraction contact
- 610: segment
- 71,72,73,74: bar
- 75,76,77: curve
- c1: cell pitch
- d1: depth of second trench
- d2: depth of base layer
- L1: main extension direction
- R1: first reference design
- R2: second reference design
- s1: edge-to-edge distance
- Ve: emitter potential

## Claims

1. A power semiconductor device (1) with a semiconductor body (2) extending in a vertical direction between an emitter side (21) with an emitter electrode (51) and a collector side (22) opposite the emitter side (21), the power semiconductor device (1) comprising:
- a drift layer (26) of a first conductivity type;
- a base layer (28) of a second conductivity type different than the first conductivity type extending between the drift layer (26) and the emitter side (21);
- a source region (29) of the first conductivity type arranged on a side of the base layer (28) facing away from the drift layer (26);
- at least one first trench (3) extending from the emitter side (21) into the drift layer (26);
- an insulated trench gate electrode (30) extending into the first trench (3);
- at least one second trench (4) extending from the emitter side (21) into the drift layer (26), the at least one second trench (4) being arranged on a side of the at least one first trench (3) facing away from the source region (29);
- an electrically conductive layer (41) extending into the second trench (4), the electrically conductive layer (41) being electrically insulated from the base layer (28) and the drift layer (26);
wherein
- a portion (281) of the base layer (28) arranged on a side of the at least one second trench (4) facing away from the at least one first trench (3) extends from the emitter side (21) at least as deep in the vertical direction towards the collector side (22) as the at least one second trench (4); and
- a sub-region (6) of the power semiconductor device (1) extending between the at least one first trench (3) and the at least one second trench (4) comprises a charge carrier extraction contact (61) electrically connected to the base layer (28).

2. The power semiconductor device (1) according to claim 1,
wherein during operation of the power semiconductor device (1), the charge carrier extraction contact (61) is electrically addressable separately from the emitter electrode (51).

3. The power semiconductor device (1) according to claim 1,
wherein the charge carrier extraction contact (61) is electrically connected to the emitter electrode (51).

4. The power semiconductor device (1) according to any of the preceding claims,
wherein during operation of the power semiconductor device (1), the electrically conductive layer (41) is at the same voltage as the emitter electrode (51) or at a positive voltage with respect to the emitter electrode (51).

5. The power semiconductor device (1) according to any of the preceding claims,
wherein the charge carrier extraction contact (61) is subdivided in a plurality of segments (610), wherein the segments (610) are arranged beside one another in a direction extending in parallel to a main extension direction (L) of the at least one first trench (3).

6. The power semiconductor device (1) according to any of the preceding claims,
wherein an edge-to-edge distance (s1) between the at least one first trench (3) and the at least one second trench (4) is between 0.5 µm and 5 µm inclusive.

7. The power semiconductor device (1) according to any of the preceding claims,
wherein the at least one first trench (3) and the at least one second trench (4) have the same depth in the vertical direction.

8. The power semiconductor device (1) according to any of the preceding claims,
wherein an enhancement layer (27) of the first conductivity type is arranged in regions between the drift layer (26) and the base layer (28), wherein the enhancement layer (27) is more heavily doped than the drift layer (26).

9. The power semiconductor device (1) according to claim 8,
wherein the enhancement layer (27) is arranged between the at least one first trench (3) and the at least one second trench (4) .

10. The power semiconductor device (1) according to any of the preceding claims,
wherein the portion (281) extends below the at least one second trench towards the at least one first trench (3).

11. The power semiconductor device (1) according to any of the preceding claims,
wherein the portion (281) of the base layer (2) extends in a cross-sectional view of the power semiconductor device (1) in a lateral direction between two partial regions (41) of the at least one second trench (4).

12. The power semiconductor device (1) according to claim 11,
wherein the at least one second trench (4) contiguously forms the two partial regions (41) of the second trench (4).

13. The power semiconductor device (1) according to claim 12,
wherein the at least one second trench (4) forms a closed loop enclosing the portion (281) of the base layer (28) when seen in the vertical direction.

14. The power semiconductor device (1) according to any of claims 11 to 13,
wherein the two partial regions (41) of the at least one second trench (4) are arranged between two partial regions (39) of the at least one first trench (3) in a cross-sectional view of the power semiconductor device (1).

15. The power semiconductor device (1) according to any of the preceding claims,
wherein the power semiconductor device (1) is an insulated gate bipolar transistor (IGBT).
